Europäisches Patentamt

European Patent Office

Office européen des brevets

(11) Publication number: **0 632 282 A2**

# EUROPEAN PATENT APPLICATION

(21) Application number: **94108371.9**

(22) Date of filing: **31.05.94**

(51) Int. Cl.6: **G01R 31/318**, G06F 11/26

(30) Priority: **29.06.93 JP 159660/93**

(43) Date of publication of application:
**04.01.95 Bulletin 95/01**

(84) Designated Contracting States:
**DE FR GB IT**

(71) Applicant: **FUJITSU LIMITED**
**1015, Kamikodanaka**
**Nakahara-ku**
**Kawasaki-shi**
**Kanagawa 211 (JP)**
Applicant: **FUJITSU VLSI LIMITED**
**1844-2, Kozoji-cho 2-chome**
**Kasugai-shi**
**Aichi 487 (JP)**

(72) Inventor: **Seki, Teruo, c/o Fujitsu VLSI Limited**
**1844-2, Kozoji-cho 2-chome**
**Kasugai-shi,**
**Aichi, 487 (JP)**

(74) Representative: **Stebbing, Timothy Charles et al**
**Haseltine Lake & Co.**
**Hazlitt House**
**28 Southampton Buildings**
**Chancery Lane**
**London WC2A 1AT (GB)**

(54) Semiconductor integrated circuit device with test mode switching.

(57) A mode selector is disclosed, for causing a testing circuit (29) in an LSI to test an internal circuit (22) of the LSI. The mode selector includes an N channel MOS transistor (25) having a source, and a gate and drain which are connected to an input terminal (21) of the LSI, and a P channel MOS transistor (26) having a gate, a source connected to the source of the N channel MOS transistor and a drain for outputting a mode change signal to the testing circuit (29) based on a control voltage to be applied to the gate of the P channel MOS transistor (26). The mode selector further includes a voltage supplying circuit (24) for applying the control voltage to the gate of the P channel MOS transistor (26). The control voltage is so set as to turn the N channel MOS transistor and the P channel MOS transistor on, when a voltage higher than the normal operation voltage is applied to the input terminal (21).

Fig. 2

EP 0 632 282 A2

## BACKGROUND OF THE INVENTION

Field of the Invention

The present invention relates to a semiconductor integrated circuit device (LSI), and, more particularly, to a technique of switching the operation mode of an LSI between a normal mode and a test mode in response to a control instruction externally supplied.

Description of the Related Art

An LSI generally has various circuits to accomplish predetermined functions and a testing circuit for testing the performance of the LSI. Before the delivery of each LSI, the testing circuit is activated to check whether the LSI properly performs desired functions.

Fast progress has been made on the large scale integration and high performance of recent LSIs. Therefore, testing for the performance of LSIs requires that an increase in testing time should be suppressed and the statuses of various circuits should be monitored through external terminals. For a semiconductor memory whose memory cells are accessed bit by bit, for example, if 4-bit memory cells are accessed at a time for the test, the number of accesses becomes 1/4, thus shortening the overall testing time. There are various methods to externally control the testing circuit of an LSI to switch the operation mode of the LSI to the test mode. One typical method to switch the operation mode is to set the voltage applied to an external input terminal higher than the normal operation voltage.

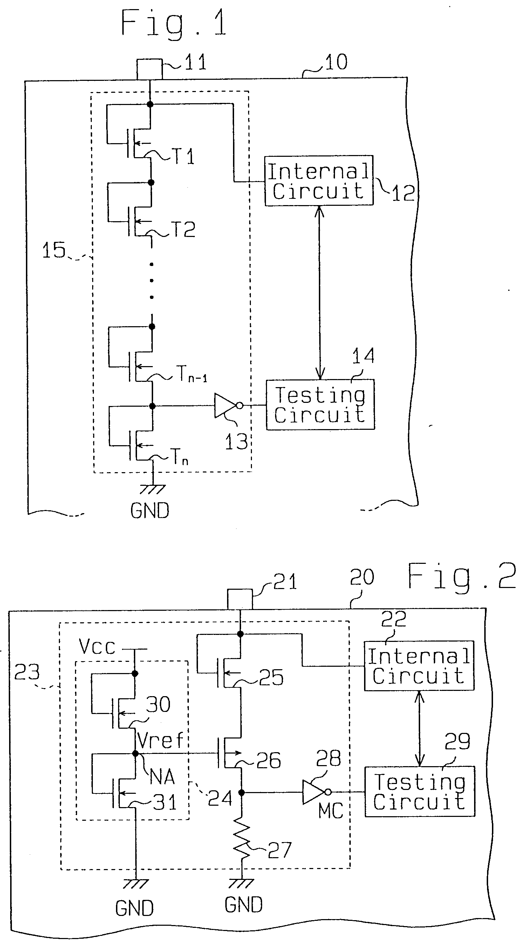

Fig. 1 shows a part of a conventional LSI. An external input terminal 11 of an LSI 10 is connected to an internal circuit 12 which accomplishes predetermined functions. An operation voltage of the LSI 10 in normal operation mode lies between a supply voltage Vcc and ground potential GND. When a signal voltage lying between a supply voltage Vcc and ground potential GND is applied to the input terminal 11, the LSI 10 becomes the normal operation mode and the internal circuit 12 functions. An operation-mode selector 15 is connected to the input terminal 11 to switch the operation mode of the LSI 10 between the normal mode and test mode. The selector 15 comprises n N channel MOS transistors T1 to Tn connected in series between the input terminal 11 and ground GND, and an invertor 13. Each of the transistors T1 to Tn has a gate connected to its drain. The drain of the transistor Tn is connected via the invertor 13 to a testing circuit 14. The threshold voltage (n•VthN) of the transistors T1-Tn is set larger than the normal operation voltage (i.e., the voltage of the power supply Vcc).

When a voltage equal to or lower than the voltage of the power supply Vcc is applied to the input terminal 11, the individual transistors T1-Tn are turned off. Consequently, the output of the invertor 13 becomes an H level so that the testing circuit 14 does not function. When a voltage $V_H$ higher than the threshold voltage (n•VthN) is applied to the input terminal 11, the individual transistors T1-Tn are turned on. As a result, the output of the invertor 13 becomes an L level, allowing the testing circuit 14 to function. The testing circuit 14 then tests the function of the internal circuit 12.

During the fabrication of the N channel MOS transistors T1-Tn in this operation-mode selector 15, the actual threshold voltages VthN of the individual transistors vary by ΔVthN with respect to the target threshold voltage. Therefore, the sum of the threshold voltages of the whole MOS transistors may have a variation of (n•ΔVthN).

In the operation-mode selector 15, the value of a high voltage $V_H$ is adjusted by changing the number of MOS transistors. It is therefore inevitable that the high voltage $V_H$ should be adjusted only by the units of the threshold voltage VthN of the MOS transistors and cannot be adjusted continuously.

## SUMMARY OF THE INVENTION

It is therefore a primary object of the present invention to provide a semiconductor integrated circuit device which has a smaller variation in high voltage to switch the operation mode, in spite of a production variation in MOS transistors.

It is another object of the present invention to provide a semiconductor integrated circuit device which can continuously perform fine adjustment of a high voltage to change the operation mode.

To achieve the foregoing and other objects and in accordance with the purpose of the present invention, an improved semiconductor integrated circuit device is provided. The semiconductor integrated circuit device according to the present invention comprises an input terminal for receiving an external signal of which the voltage level is variable. The circuit device further comprises an internal circuit, a testing circuit and a mode selector. The internal circuit accomplishes a predetermined function based on a normal operation voltage supplied via the input terminal. The testing circuit tests the function of the internal circuit.

The mode selector causes the testing circuit to test the internal circuit. The mode selector includes an N channel MOS transistor having a source, and a gate and drain which are connected to the input terminal, and a P channel MOS transistor having a gate, a source connected to the source of the N channel MOS transistor and a drain for outputting a mode change signal to the testing circuit based on a control voltage to be applied to the gate of the P channel MOS transistor. The mode selector further includes a voltage supplying circuit for applying the control voltage to the gate of the P channel MOS transistor. The control voltage is so set as to turn the N channel MOS transistor and the P channel MOS transistor on, when a voltage higher than the normal operation voltage is applied to the input terminal.

## BRIEF DESCRIPTION OF THE DRAWINGS

The features of the present invention that are believed to be novel are set forth with particularity in the appended claims. The invention, together with objects and advantages thereof, may best be understood by reference to the following description of the presently preferred embodiments together with the accompanying drawings in which:

Fig. 1 is a circuit diagram illustrating an LSI having a conventional operation-mode selector incorporated therein;

Fig. 2 is a circuit diagram illustrating an LSI in which an operation-mode selector according to a first embodiment of the present invention is incorporated;

Fig. 3 is a circuit diagram illustrating an LSI in which an operation-mode selector according to a second embodiment of the present invention is incorporated;

Fig. 4 is a circuit diagram illustrating an LSI in which an operation-mode selector according to a third embodiment of the present invention is incorporated;

Figs. 5, 6, 7 and 8 are circuit diagrams showing respectively modifications of operation-mode selectors; and

Fig. 9 is a block diagram showing a semiconductor memory device which embodies the present invention.

## DETAILED DESCRIPTION OF THE PREFERRED EMBODIMENTS

A first embodiment according to the present invention will now be described referring to Fig. 2. An LSI 20 has at least one external input terminal 21. The input terminal 21 of the LSI 20 is connected to an internal circuit 22 which includes an address buffer (not shown), and serves as both an input terminal for normal signals and an input terminal for a mode change signal. When a signal voltage lying between a normal operation voltage Vcc and ground potential GND is applied to the input terminal 21, this internal circuit 22 functions. The LSI 20 also includes an operation-mode selector 23 provided between the input terminal 21 and the ground GND.

The operation-mode selector 23 comprises an N channel MOS transistor 25, P channel MOS transistors 26, a resistor 27 as a guarantee circuit, an invertor 28 and a voltage generator 24. The transistor 25 has a gate and drain which are connected to the input terminal 21. The transistor 26 has a source connected to the source of the transistor 25, a drain connected via a resistor 27 to the ground GND, and a gate connected to the voltage generator 24. A control voltage Vref is applied to the gate of the transistor 26. The drain of the transistor 26 is connected to the invertor 28. Let us denote the threshold voltage of the N channel MOS transistor 25 by VthN and the threshold voltage of the P channel MOS transistor 26 by VthP.

When the input signal to the invertor 28 becomes an H level, the invertor 28 outputs an L-level mode change signal MC to a testing circuit 29. The resistor 27, which has a high resistance, serves to connect the drain of the transistor 26 to the ground GND when the transistor 26 is turned off, thus inhibiting the supply of the mode change signal MC to the testing circuit 29.

The voltage generator 24 comprises two N channel MOS transistors 30 and 31 of one conductivity type, connected in series between the operation voltage Vcc and the ground GND. Each of the transistors 30 and 31 has its gate and drain connected together. Let us denote the threshold voltage of both transistors 30 and 31 by VthN. When the operation voltage Vcc is supplied to the transistors 30 and 31, therefore, both transistors 30 and 31 are turned on and the voltage level at a node NA between the transistors 30 and 31 becomes the control voltage Vref. At this time, the control voltage Vref is expressed by an equation (1) below.

$$Vref = Vcc - VthN \qquad (1)$$

When a signal voltage lying between the normal operation voltage Vcc and ground potential GND is applied to the input terminal 21, therefore, the transistors 25 and 26 are turned off because the control voltage Vref is (Vcc - VthN). The voltage level of the drain of the transistor 26 is set to the ground potential GND by the resistor 27, causing the invertor 28 to have an H-level output. Therefore, the testing circuit 29 does not function and the internal circuit 22 alone functions.

A high voltage $V_H$ which should be applied to the input terminal 21 to function the testing circuit 29 or to function the operation-mode selector 23 is expressed by an equation (2).

$$V_H = Vref + VthN + VthP \qquad (2)$$

Thus, by substituting the equation (1) into the equation (2), the high voltage $V_H$ in this embodiment can also be expressed by the following equation (3).

$V_H \fallingdotseq$ Vcc - VthN + VthN + VthP

= Vcc + VthP (3)

It is apparent from the equation (3) that the high voltage $V_H$ depends only on the threshold voltage VthP of the P channel MOS transistor 26.

When a voltage equal to or greater than the high voltage $V_H$ given in the equation (3) is applied to the input terminal 21, the transistors 25 and 26 are turned on. Consequently, the level of the drain of the transistor 26 becomes an H level and the invertor 28 outputs the L-level mode change signal MC, permitting the testing circuit 29 to function.

According to this embodiment, as mentioned above, the high voltage $V_H$ is determined by the threshold voltage VthP of the ordinary P channel MOS transistor 26. It is therefore possible to reduce a variation in high voltage $V_H$, caused by a production variation in MOS transistors, only to a variation in the threshold voltage of one stage of a P channel MOS transistor.

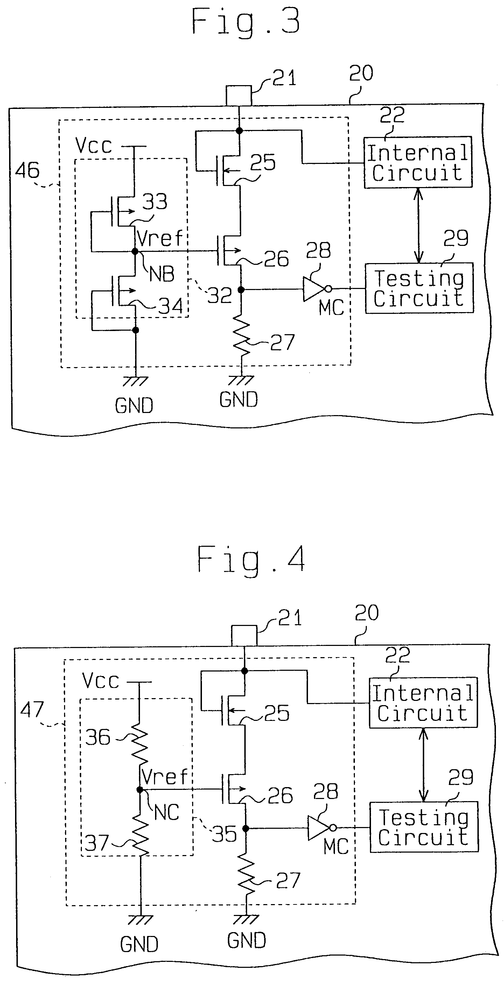

Fig. 3 illustrates a second embodiment of the present invention. A voltage generator 32 in an operation-mode selector 46 in this embodiment comprises two P channel MOS transistors 33 and 34 of one conductivity type, connected in series between the operation voltage Vcc and the ground GND. Each of the transistors 33 and 34 has its gate and drain connected together. Let us denote the threshold voltage of both transistors 33 and 34 by VthP. When the operation voltage Vcc is supplied to the transistors 33 and 34, therefore, both transistors 33 and 34 are turned on and the voltage level at a node NB between the transistors 33 and 34 becomes the control voltage Vref. At this time, the control voltage Vref is expressed by the following equation (4).

Vref = Vcc - VthP (4)

When a signal voltage lying between the normal operation voltage Vcc and ground potential GND is applied to the input terminal 21, therefore, the transistors 25 and 26 are turned off because the control voltage Vref is (Vcc - VthP). The voltage level of the drain of the transistor 26 is set to the ground potential GND by the resistor 27, causing the invertor 28 to have an H-level output. Therefore, the testing circuit 29 does not function and the internal circuit 22 alone functions.

The high voltage $V_H$ which should be applied to the input terminal 21 to function the testing circuit 29 or to function the operation-mode selector 23 is expressed by an equation (5) which is obtained by substituting the equation (4) into the equation (2).

$V_H \fallingdotseq$ Vcc - VthP + VthN + VthP

= Vcc + VthN (5)

It is apparent from the equation (5) that the high voltage $V_H$ depends only on the threshold voltage VthN of the N channel MOS transistor 25. When a voltage equal to or greater than the high voltage $V_H$ given in the equation (5) is applied to the input terminal 21, the transistors 25 and 26 are turned on and the invertor 28 outputs the L-level mode change signal MC, permitting the testing circuit 29 to function.

According to this embodiment, the high voltage $V_H$ is determined by the threshold voltage VthN of the ordinary N channel MOS transistor 25. It is therefore possible to reduce a variation in high voltage $V_H$, caused by a production variation in MOS transistors, only to a variation in the threshold voltage of one stage of an N channel MOS transistor.

Fig. 4 illustrates a third embodiment of the present invention. A voltage generator 35 in an operation-mode selector 47 in this embodiment comprises two resistors 36 and 37 which are connected in series between the operation voltage Vcc and the ground GND. The resistance of the resistor 37 is set greater than the resistance of the resistor 36, so that the voltage level at a node NC between both resistors 36 and 37 becomes the control voltage Vref which is approximately the operation voltage Vcc.

When the high voltage $V_H$ given in the equation (2) is applied to the input terminal 21, the transistors 25 and 26 are turned on based on the control voltage Vref, and the invertor 28 outputs the L-level mode change signal MC, permitting the testing circuit 29 to function.

According to this embodiment, the high voltage $V_H$ is determined by the threshold voltages VthN and VthP of the ordinary N and P channel MOS transistors 25 and 26. It is therefore possible to reduce a variation in high voltage $V_H$, caused by a production variation in MOS transistors, only to variations in the threshold voltages of two stages of MOS transistors.

Further, fine adjustment of the control voltage Vref can be continuously performed by finely adjusting the ratio of the resistance of the resistor 36 to that of the resistor 37. As it is apparent from the equation (2) that the high voltage $V_H$ also depends on the control voltage Vref, fine adjustment of the high voltage $V_H$ can be carried out continuously by finely adjusting the control voltage Vref.

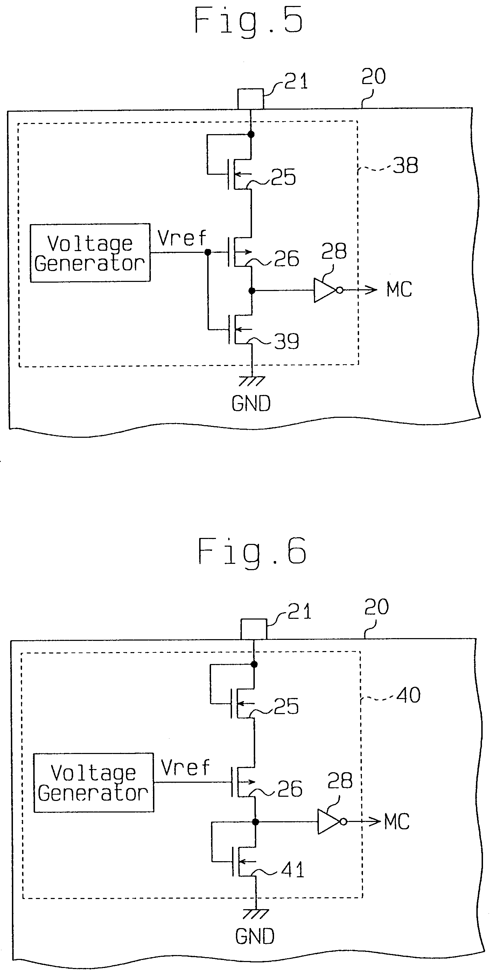

Figs. 5 through 8 show different modifications of the operation-mode selectors.

An operation-mode selector 38 shown in Fig. 5 has an N channel MOS transistor 39 that serves as a high-resistance guarantee circuit, in place of the resistor 27 shown in Figs. 2, 3 and 4. The transistor 39 has a drain connected to the drain of the transistor 26, a source connected to the ground GND, and a gate to which the control voltage Vref is applied. When the transistor 26 is turned off, the voltage level of the drain of the transistor 26 becomes the ground level GND due to the function of the transistor 39.

An operation-mode selector 40 shown in Fig. 6 has an N channel MOS transistor 41 that serves as a high-resistance guarantee circuit, in place of the resistor 27 shown in Figs. 2, 3 and 4. The transistor 41 has a drain and gate which are connected to the drain of the transistor 26, and a source connected to the ground GND. When the transistor 26 is turned off, the voltage level of the drain of the transistor 26 becomes the ground level GND due to the function of the transistor 41.

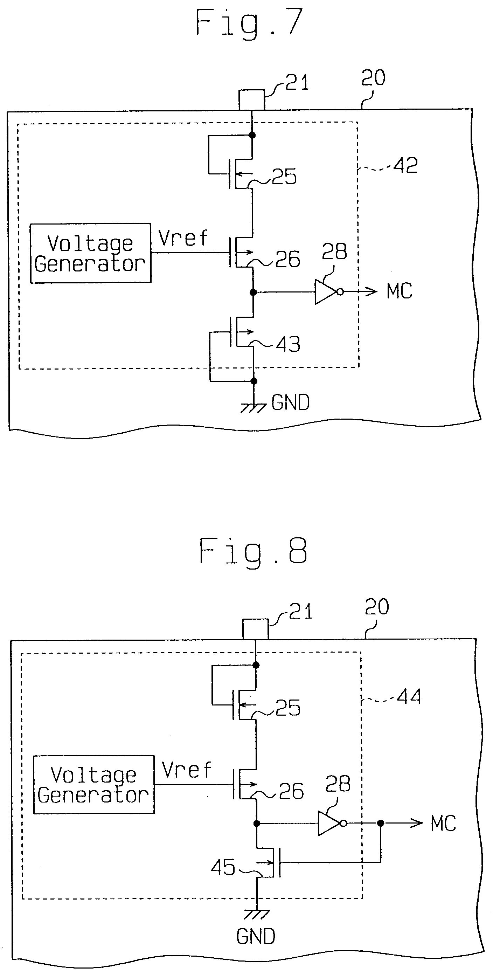

An operation-mode selector 42 shown in Fig. 7 has a P channel MOS transistor 43 that serves as a high-resistance guarantee circuit, in place of the resistor 27 shown in Figs. 2, 3 and 4. The transistor 43 has a source connected to the drain of the transistor 26, and a drain and gate which are connected to the ground GND. When the transistor 26 is turned off, the voltage level of the drain of the transistor 26 becomes the ground level GND due to the function of the transistor 43.

An operation-mode selector 44 shown in Fig. 8 has an N channel MOS transistor 45 that serves as a high-resistance guarantee circuit, in place of the resistor 27 shown in Figs. 2, 3 and 4. The transistor 45 has a drain connected to the drain of the transistor 26, a source connected to the ground GND, and a gate connected to the output terminal of the invertor 28. When the output of the invertor 28 becomes an H level or the LSI 20 is in a normal operation mode, the transistor 45 is turned on and the voltage level of the drain of the transistor 26 becomes the ground level GND.

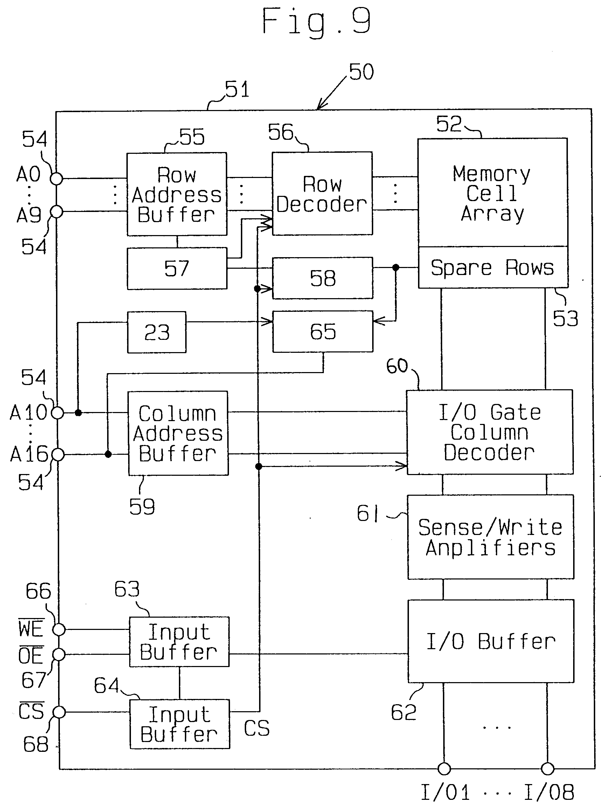

Fig. 9 shows a semiconductor memory device which embodies the present invention. This memory device is a static random access memory (SRAM) 50 in which a memory cell array 52 having many memory cells is provided on a chip 51. This memory cell array 52 includes spare rows 53 of redundant cells which would replace defective cells among the memory cells of the array 52.

The chip 51 has a plurality of address terminals 54 (seventeen terminals in this embodiment) formed at one edge portion. The chip 51 receives row address signals A0 to A9 via ten address terminals 54 and receive column address signals A10 to A16 via seven address terminals 54. The address signals A0-A9 are output via a row address buffer 55 to a row decoder 56 and a redundancy determining circuit 57 which determines whether the address is a redundant address. The address signals A10-A16 are output via a column address buffer 59 to an input/output (I/O) gate/column decoder 60.

The row address buffer 55 is connected to the row decoder 56, which is connected to the memory cell array 52. The redundancy determining circuit 57 is connected to a redundant decoder 58, which is connected to the spare rows 53. The column address buffer 59 is connected to the I/O gate/column decoder 60, which is connected to both the memory cell array 52 and the spare rows 53. The I/O gate/column decoder 60 is also connected to a sense amplifier/write amplifier 61, which is connected to an input/output (I/O) buffer 62. The I/O buffer 62 is connected to data terminals I/O1 to I/O8 provided at one edge portion of the chip 51.

An input buffer 63 receives a write enable signal /WE and an output enable signal /OE via two input terminals 66 and 67 provided at one edge portion of the chip 51. The input buffer 63 controls the I/O buffer 62 based on both signals /WE and /OE. An input buffer 64 receives a chip select signal /CS via an input terminal 68 provided at one edge portion of the chip 51 and outputs an activate signal CS to the row decoder 56, redundant decoder 58 and column decoder 60.

The redundancy determining circuit 57 has a plurality of fuses (not shown) for the number of bits of the address signals A0-A9. When any of those fuses is cut, a redundant address for accessing a redundant cell in the spare rows 53 is set. When the address that is specified by the address signals A0-A9 does not match with the redundant address, the redundancy determining circuit 57 outputs the activate signal to the row decoder 56 so as to enable the decoder 56. When the address that is specified by the address signals A0-A9 matches with the redundant address, the redundancy determining circuit 57 disables the row decoder 56 and enables the redundant decoder 58.

Based on the activate signal CS and the activate signal from the redundancy determining circuit 57, the row decoder 56 decodes the address signals A0-A9 and selects a specific word line (not shown) in the memory cell array 52 based on the decoding result. The I/O gate/column decoder 60 decodes the address signals A10-A16 and selects a specific pair of bit lines (not shown) in the memory cell array 52 based on the decoding result. Consequently, data of a cell connected to the selected word line and the selected bit line pair is read out via the bit line pair. The read data is amplified by the sense amplifier 61 and the amplified data is sent via the I/O buffer 62 to the I/O terminals I/O1 to I/O8.

The redundant decoder 58 selects a redundant word line (not shown) in the spare rows 53, based on the activate signal CS and the activate signal from the redundancy determining circuit 57. At this time, a specific pair of bit lines (not shown) in the spare rows 53 is selected by the column decoder 60. As a result, data of a redundant cell connected to the selected redundant word line and the selected bit line pair is read out via the bit line pair. The read data is amplified by the sense amplifier 61 and the amplified data is sent via the I/O buffer 62 to the I/O terminals I/O1 to I/O8.

The address terminal 54 to which the address signal A10 is input is connected to the aforementioned operation-mode selector 23 as shown in Fig. 2, 3 or 4. The selector 23 is connected to a redundant address detector 65 which detects the redundant address. In this SRAM 50, the address terminal 54 for the address signal A10 corresponds to the external input terminal 21 as shown in Fig. 2, 3 or 4, and the redundant address detector 65 corresponds to the testing circuit 29 as shown in Fig. 2, 3 or 4. Further, the column address buffer 59 and all the circuits which are connected to this buffer 59 correspond to the internal circuit 22 as shown in Fig. 2, 3 or 4.

When a voltage higher by a value $\alpha$ than the normal operation voltage Vcc is applied to the address terminal 54 to which the address signal A10 is input, the selector 23 outputs a signal to enable the detector 65.

The detector 65 receives the output signal of the redundant decoder 58. The output terminal of the detector 65 is connected to the address terminal 54 to which the address signal A16 is input. Upon reception of the activate signal from the selector 23, the detector 65 is enabled to detect the voltage level at the output terminal of the redundant decoder 58. When the voltage level at the output terminal of the redundant decoder 58 is an H level, the detector 65 outputs the detection result from the address terminal 54 for the address signal A16. The address signals A0-A9 at this time are acknowledged as a redundant row address by the testing device (not shown).

Although several embodiments of the present invention have been described herein, it should be apparent to those skilled in the art that the present invention may be embodied in many other specific forms without departing from the spirit or scope of the invention.

Therefore, the present examples and embodiments are to be considered as illustrative and not restrictive, and the invention is not to be limited to the details given herein, but may be modified within the scope of the appended claims.

## Claims

1. A semiconductor integrated circuit device comprising:

an input terminal (21) for receiving an external signal of which the voltage level is variable;

an internal circuit (22) for accomplishing a predetermined function based on a normal operation voltage supplied via said input terminal;

a testing circuit (29) for testing said function of said internal circuit; and

a mode selector (23) for causing said testing circuit to test said internal circuit, characterized in that the mode selector includes:

a first transistor of the first conductivity type (25), having a source, and a gate and drain which are connected to said input terminal;

a second transistor of the second conductivity type (26), having a gate, a source connected to said source of said first transistor and a drain for outputting a mode change signal to said testing circuit based on a control voltage (Vref) to be applied to said gate of said second transistor;

voltage supplying means (24) for applying said control voltage (Vref) to said gate of said second transistor; and

said control voltage (Vref) being so set as to turn said first transistor and said second transistor on, when a voltage higher than said normal operation voltage is applied to said input terminal.

2. The semiconductor integrated circuit device according to Claim 1, wherein said mode selector further comprises a guarantee circuit, provided between a ground and said drain of said second transistor (26), for connecting said drain of said second transistor (26) to said ground to inhibit said mode change signal from being supplied to said testing circuit when said normal operation voltage is applied to said external input terminal.

3. The semiconductor integrated circuit device according to Claim 2, wherein said guarantee circuit includes a resistor (27) provided between said ground and said drain of said second transistor (26).

4. The semiconductor integrated circuit device according to Claim 2, wherein said guarantee circuit includes a transistor of the first conductivity type (39) having a drain connected to said drain of said second transistor, a source connected to said ground, and a gate to which said control voltage (Vref) is applied.

5. The semiconductor integrated circuit device according to Claim 2, wherein said guarantee circuit includes a transistor of the first conductivity type (41) having a drain and gate connected to said drain of said second transistor, and a source connected to said ground.

6. The semiconductor integrated circuit device according to Claim 2, wherein said guarantee circuit includes a transistor of the second conductivity type (43) having a source connected to said drain of said second transistor, and a drain and gate connected to said ground.

7. The semiconductor integrated circuit device according to Claim 2, wherein said guarantee circuit includes a transistor of the first conductivity type (45) having a drain connected to said drain of said second transistor, a source connected to said ground, and a gate connected via an invertor to said drain of said first transistor.

8. The semiconductor integrated circuit device according to Claim 1, wherein said power supplying means includes a voltage generator (24,32,35) for generating said control voltage (Vref) based on said normal operation voltage and for outputting said control voltage.

9. The semiconductor integrated circuit device according to Claim 8, wherein said voltage generator comprises two MOS transistors of one conductivity type, connected in series between said normal operation voltage and a ground, each of said MOS transistors having a gate and drain connected together, a potential between said MOS transistors being said control voltage (Vref).

10. The semiconductor integrated circuit device according to Claim 9, wherein said MOS transistors of one conductivity type are N channel MOS transistors.

11. The semiconductor integrated circuit device according to Claim 9, wherein said MOS transistors of one conductivity type are P channel MOS transistors.

12. The semiconductor integrated circuit device according to Claim 8, wherein said voltage generator comprises at least two resistors (36,37), connected in series between said normal operation voltage and a ground, for dividing said normal operation voltage to generate said control voltage (Vref).

13. A mode selecting circuit for use in a semiconductor integrated circuit device including an input terminal (21) for receiving an external signal of which the voltage level is variable, an internal circuit (22) for accomplishing a predetermined function based on a normal operation voltage supplied via the input terminal, and a testing circuit (29) for testing the function of the internal circuit, wherein the mode selecting circuit (23) causes the testing circuit to test the internal circuit, characterized by comprising:
    a first transistor of the first conductivity type (25) having a source, and a gate and drain which are connected to the input terminal;
    a second transistor of the second conductivity type (26) having a gate, a source connected to said source of said first transistor and a drain for outputting a mode change signal to the testing circuit based on a control voltage (Vref) to be applied to said gate of said second transistor;
    voltage supplying means (24) for applying said control voltage (Vref) to said gate of said second transistor; and
    said control voltage (Vref) being so set as to turn said first transistor and said second transistor on, when a voltage higher than the normal operation voltage is applied to the input terminal.

14. The mode selecting circuit according to Claim 13 further comprising a guarantee circuit, provided between a ground and said drain of said second transistor (26), for connecting said drain of said second transistor (26) to said ground to inhibit said mode change signal from being supplied to the testing circuit when the normal operation voltage is applied to the external input terminal.

15. The mode selecting circuit according to Claim 13, wherein the first conductivity type is N channel type, and the second conductivity type is P channel type.

16. A circuit for detecting an instruction signal externally supplied thereto and for switching the operation mode of an other circuit (22,29) based on the instruction signal, comprising:
    an input terminal (21) for receiving the instruction signal of which the voltage level is variable;
    a first transistor of the first conductivity type (25) having a source, and a gate and drain which are connected to said input terminal;

a second transistor of the second conductivity type (26) having a gate, a source connected to said source of said first transistor and a drain for outputting a mode change signal to the other circuit based on a control voltage (Vref) to be applied to said gate of said second transistor;

voltage supplying means (24) for applying said control voltage (Vref) to said gate of said second transistor; and

said control voltage (Vref) being so set as to turn said first transistor and said second transistor on, when a voltage higher than a predetermined normal operation voltage is applied to the input terminal.

# Fig.1

# Fig.2

# Fig.3

# Fig.4

Fig.5

Fig.6

# Fig.7

# Fig.8

# Fig.9